(19) Europäisches Patentamt / European Patent Office / Office européen des brevets

(11) **EP 1 990 648 B1**

(12) **EUROPÄISCHE PATENTSCHRIFT**

(45) Veröffentlichungstag und Bekanntmachung des Hinweises auf die Patenterteilung:
**14.08.2013 Patentblatt 2013/33**

(51) Int Cl.:
**G01R 33/3815** *(2006.01)* **G01R 33/60** *(2006.01)*
**H01F 6/00** *(2006.01)*

(21) Anmeldenummer: **08008146.6**

(22) Anmeldetag: **29.04.2008**

(54) **Supraleitende Magnetanordnung mit hysteresenfreier Feldspule**

Superconductive magnet assembly with hysteresis-free magnetic coils

Agencement d'aimants supraconducteurs doté d'une bobine de champs sans hystérèse

(84) Benannte Vertragsstaaten:
**CH FR GB LI**

(30) Priorität: **08.05.2007 DE 102007021463**

(43) Veröffentlichungstag der Anmeldung:
**12.11.2008 Patentblatt 2008/46**

(73) Patentinhaber: **Bruker BioSpin AG**
**8117 Fällanden (CH)**

(72) Erfinder:
• **Venturini, Francesca**
**8600 Dübendorf (CH)**
• **Schauwecker, Robert**
**8004 Zurich (CH)**
• **Bovier, Pierre-Alain**
**8051 Zürich (CH)**

(74) Vertreter: **Kohler Schmid Möbus**
**Patentanwälte**
**Ruppmannstraße 27**
**70565 Stuttgart (DE)**

(56) Entgegenhaltungen:
**DE-A1- 10 041 672 DE-A1- 10 041 677**

• **M.J. NILGES ET AL.: APPL. MAG. RESON, Bd. 16, 1999, Seiten 167-183, XP002602061**
• **D. SCHMALBEIN ET AL.: APPL. MAG. RESON, Bd. 16, 1999, Seiten 185-205, XP002602062**
• **A.F. GULLÄ ET AL.: CONCEPTS IN MAGNETIC RESONANCE, Bd. 15, 2002, Seiten 201-207, XP002602063**

**Beschreibung**

Die Erfindung betrifft eine Magnetanordnung zur Erzeugung eines Magnetfeldes in Richtung einer z-Achse in einem auf der z-Achse um z=0 angeordneten Arbeitsvolumen mit einem Magnetspulensystem, welches ein oder mehrere supraleitende Magnetteilspulensysteme umfasst, welche im Betriebszustand je supraleitend kurzgeschlossene Strompfade bilden, wobei das Magnetspulensystem Typ-2-Supraleitermaterial umfasst, welches sich im Betriebszustand in einem Magnetfeld oberhalb seiner unteren kritischen Kraftflussdichte befindet, und mit einem weiteren Spulensystem zur Erzeugung einer Magnetfeldänderung, welches unabhängig vom Magnetspulensystem geladen oder entladen werden kann, und welches ein erstes und ein zweites Teilspulensystem umfasst, wobei das erste Teilspulensystem und das zweite Teilspulensystem mindestens je eine Spule umfassen, wobei alle Spulen des weiteren Spulensystems miteinander in Serie geschaltet sind, wobei $\left| g_C^{eff, diamag} \right| > 0.1 mT / A$.

Die genannte Größe hat folgende Bedeutung:

$$g_C^{eff, diamag} = g_C - g_A^{\mathsf{T}} \cdot \left( L_A^{diamag} \right)^{-1} \cdot L_{C \to A}^{diamag} + g_M$$

mit:

$g_C$: Feld pro Ampere Strom des weiteren Spulensystems im Arbeitsvolumen ohne die Feldbeiträge der Magnetteilspulensysteme und ohne den Feldbeitrag der Magnetisierung von Supraleitermaterial in der Magnetanordnung,

$$g_A^{\mathsf{T}} = (g_{A1}, \ldots, g_{Aj}, \ldots g_{An}),$$

$g_{Aj}$: Feld pro Ampere Strom des j-ten Magnetteilspulensystems im Arbeitsvolumen ohne die Feldbeiträge der i-ten Magnetteilspulensysteme für i ≠ j und ohne die Feldbeiträge des weiteren Spulensystems und der Magnetisierung von Supraleitermaterial in der Magnetanordnung,

$L_A^{diamag}$ : n x n Matrix der der Eigeninduktivitäten und des induktiven Kopplungen zwischen den Magnetteilspulensystemen bei vollständiger diamagnetischer Verdrängung von Feldänderungen aus dem supraleitenden Materialanteil in der Magnetanordnung,

$$L_{C \to A}^{diamag} = \begin{pmatrix} L_{C \to A1}^{diamag} \\ \vdots \\ L_{C \to An}^{diamag} \end{pmatrix}$$

$L_{C \to Ai}^{diamag}$ : Induktive Kopplungen des weiteren Spulensystems bzw. mit dem i-ten Magnetteilspulensystem bei vollständiger diamagnetischer Verdrängung von Feldänderungen aus dem supraleitenden Materialanteil in der Magnetanordnung, $g_M$ : Feld im Arbeitsvolumen, welches von der Magnetisierung von Supraleitermaterial in der Magnetanordnung bei einer Stromänderung von einem Ampere im weiteren Spulensystem herrührt, bei vollständiger diamagnetischer Verdrängung von Feldänderungen aus dem supraleitenden Materialanteil in der Magnetanordnung und bei Berücksichtigung der induzierten Ströme in den Magnetteilspulensystemen.

Eine derartige Magnetanordnung ist bereits aus [1] bekannt.

Bei Anwendungen von supraleitenden Magnetanordnungen bspw. im Bereich der Elektronenspinresonanz (= EPR/ESR) ist es notwendig, das Magnetfeld mit der Zeit möglichst linear ändern zu können (="sweepen"). Man spricht auch vom Durchfahren einer Feld-Rampe.

Um bei einem solchen Sweep-Prozess eine hohe Auflösung zu erreichen, muss zusätzlich zum supraleitenden Magnetspulensystem, das ein starkes Hintergrundfeld erzeugt, ein weiteres Spulensystem verwendet werden (auch Feldspule oder "Sweep Spule" genannt) [1]. Das Sweepen mit dem weiteren Spulensystem statt mit dem supraleitenden Magnetspulensystem selbst ist insbesondere deshalb vorteilhaft, weil der Wärmeeintrag in das supraleitende Magnetspulensystem durch die kleineren Ströme, welche beim Sweepen mit dem weiteren Spulensystem verwendet werden, reduziert werden kann [2]. Das weitere Spulensystem kann dabei normalleitend (z.B. Kupferspule mit Wasser gekühlt) oder supraleitend sein.

Ein Beispiel eines supraleitenden weiteren Spulensystems ist im kommerziellen Magnetsystem "Cryogen-free superconducting ESR 12T magnet system" von Cryogenic zu finden [3].

In [4] wird eine Magnetanordnung mit einem zusätzlichen stromführenden Spulensystem mit $\frac{g_C^{eff,class}}{g_C^{eff,diamag}} > 1.2$ beschrieben, wobei

$$g_C^{eff,class} = g_C - g_A{}^{\mathsf{T}} \cdot \left(L_A^{class}\right)^{-1} \cdot L_{C \to A}^{class},$$

$L_A^{class}$ : n x n Matrix der Eigeninduktivitäten und des induktiven Kopplungen zwischen den Magnetteilspulensystemen, unter Vernachlässigung jeder diamagnetischen Verdrängung von Feldern aus dem Supraleitermaterial in der Magnetanordnung,

$$L_{C \to A}^{class} = \begin{pmatrix} L_{C \to A1}^{class} \\ \vdots \\ L_{C \to An}^{class} \end{pmatrix},$$

$L_{C \to Ai}^{class}$ : Induktive Kopplungen des weiteren Spulensystems mit dem i-ten Magnetteilspulensystem, unter Vernachlässigung jeder diamagnetischen Verdrängung von Feldern aus dem Supraleitermaterial in der Magnetanordnung.

Es ist bekannt, dass bei Stromänderungen in supraleitenden Magneten nichtlineare Effekte bezüglich der Feldstärke auftreten können [5]. Man spricht generell von Hysterese. Das bedeutet, dass der Magnet ein Feld erzeugt, das von der Vorgeschichte des Stroms im Magneten abhängt [3, 6, 7]. Der Mechanismus, welcher in einer Magnetanordnung mit einem supraleitenden Magnetspulensystem zu Hysterese beim Durchfahren der Feld-Rampe mit einem weiteren Spulensystem führt, ist folgender: Beim Laden des weiteren Spulensystems wird normalerweise auch Feld im Volumen des supraleitenden Magnetspulensystems erzeugt. Diese Feldänderung wird anfänglich durch das Supraleitermaterial verdrängt, wodurch die effektive Feldstärke pro Ampere des weiteren Spulensystems $g_C^{eff,diamag}$ verstärkt oder abgeschwächt werden kann gegenüber dem Wert $g_C^{eff,class}$, welcher ohne Feldverdrängung durch das Supraleitermaterial resultieren würde. Die Feldverdrängung des Supraleitermaterials bei Feldänderungen aufgrund des Ladens des weiteren Spulensystems nimmt ab einer bestimmten Feldänderungsamplitude ab. In diesem Bereich verändert sich für das weitere Spulensystem die Feldstärke pro Ampère Stromänderung von $g_C^{eff,diamag}$ zu $g_C^{eff,class}$. Wenn die Laderichtung des weiteren Spulensystems geändert wird, beträgt die Feldstärke pro Ampere Stromänderung anfänglich wieder $g_C^{eff,diamag}$. Die Abhängigkeit der Feldstärke des weiteren Spulensystems vom Strom weist also eine Nichtlinearität mit einer Hysterese auf.

Darüber hinaus kann auch eine induktive Kopplung des weiteren Spulensystems mit dem Magnetspulensystem problematisch sein und wird manchmal als Quelle der Hysterese interpretiert [1].

Bei Änderungen des Magnetfeldes werden auch Wirbelströme (z.B. in den Spulenkörpern) erzeugt. Das Problem ist aus der MRI bekannt (insbesondere bei Gradientenspulen). Die Feldänderungen beim Sweepen von z.B. EPR-Systemen sind zwar normalerweise langsamer (typisch von 1 G/s bis 50 G/s [1]) als die Feldänderungen der Gradientenspulen in der MRI und die Wirbelströme daher schwächer, als Resultat ist jedoch trotzdem eine Zeitverzögerung des Feldes im Magnetzentrum zu erwarten [8].

Um trotz der Hysterese Messungen während eines Sweeps durchzuführen, sind in der Literatur die folgenden Methoden beschrieben:

In der in [6] vorgestellten Methode wird das Magnetfeld während eines Sweeps gemessen (z.B. mit Hallsonde) und der Strom direkt angepasst. Problematisch hierbei ist, dass das Feld nicht genau an der Position der Probe gemessen wird. Beim Sweepen wird die Feldmessung durch die Inhomogenität des Feldes des weiteren Spulensystems beeinflusst.

Es wird häufig eine Kalibrierung des Magneten (Messung des Magnetfelds in Abhängigkeit vom Strom B(I) mit einer bekannten Probe) durchgeführt [1, 6, 7]. Jedoch hängt die Hysterese von der Sweep-Amplitude und von der Sweep-Rate ab [5]. Diese Methode ist daher nur praktikabel, wenn nur eine Sweep- Amplitude und eine Sweep-Rate verwendet werden.

Darüber hinaus besteht die Möglichkeit, die Magnetanordnung im "Driven Mode" zu betreiben. Das Magnetspulensystem wird dabei nicht mit einem Schalter persistent gemacht, sondern das Feld wird durch das Netzgerät konstant gehalten [3]. Diese Methode benötigt aber ein zusätzliches Netzgerät, das sehr stabil sein muss. Außerdem müssen wegen des Stroms, der ständig in der Zuleitung fließen muss, hohe Verluste an Kühlflüssigkeiten hingenommen werden.

Eine Möglichkeit zur Reduzierung der Hysterese ist die Verwendung einer Feldspule, die sehr kleine Feldstärken erzeugt. In diesem Fall weist die Feld-zu-Strom Kurve des weiteren Spulensystems über den ganzen Sweep-Bereich die Anfangssteigung $g_C^{eff,diamag}$ auf und geht gar nie in den "klassischen" Bereich über.

Feldspulen mit einem kleinen "Sweep"-Bereich sind in AC-Anwendungen unter dem Namen Modulationsspulen bekannt. Solche Modulationsspulen dienen dazu, das Feld mit hoher Frequenz (Kiloherzbereich) harmonisch jedoch lediglich innerhalb eines kleinen Bereichs zu ändern. Das Durchfahren eines großen Sweep-Bereichs ist mit derartigen Modulationsspulen nicht möglich.

Aufgabe der vorliegenden Erfindung ist es demgegenüber, eine Magnetanordnung vorzuschlagen, bei der die Feldänderung im Arbeitsvolumen eine möglichst lineare Funktion der Stromänderung im weiteren Spulensystem ist, das unabhängig vom Magnetspulensystem geladen oder entladen werden kann.

Diese Aufgabe wird erfindungsgemäß dadurch gelöst, dass

$$\left| g_{C1}^{eff,diamag} \right| > 0.1\,mT/A \,,\, \left| g_{C2}^{eff,diamag} \right| > 0.1\,mT/A \,,$$

$$\frac{g_{C1}^{eff,class}}{g_{C1}^{eff,diamag}} \notin [0.95, 1.05] \,,\, \frac{g_{C2}^{eff,class}}{g_{C2}^{eff,diamag}} \notin [0.95, 1.05] \,,$$

wobei

$$\frac{g_C^{eff,class}}{g_C^{eff,diamag}} \in [0.95, 1.05] \,,$$

Der Feldbeitrag pro Ampere Strom des weiteren Spulensystems im Arbeitsvolumen unter Berücksichtigung der Feldbeiträge des weiteren Spulensystems selbst wie auch der Feldänderung aufgrund von Strömen, welche in den Magnetteilspulensystemen beim Laden oder Entladen des weiteren Spulensystems induziert werden, unter Vernachlässigung jeder diamagnetischen Verdrängung von Feldern aus dem supraleitenden Volumen der Magnetanordnung, und der Feldbeitrag pro Ampere Strom des weiteren Spulensystems im Arbeitsvolumen unter Berücksichtigung der Feldbeiträge des weiteren Spulensystems selbst wie auch der Feldänderung aufgrund von Strömen, welche in den Magnetteilspulensystemen beim Laden des weiteren Spulensystems induziert werden, mit Berücksichtigung einer vollständigen diamagnetischen Verdrängung von Feldern aus dem supraleitenden Volumen der Magnetanordnung, sowie des Feldbeitrages durch die Magnetisierungsänderung des supraleitenden Volumens der Magnetanordnung unterscheiden sich bei der erfindungsgemäßen Magnetanordnung um höchstens 5 % (d.h. $\frac{g_C^{eff,class}}{g_C^{eff,diamag}} \in [0.95, 1.05]$).

Erfindungsgemäß erzeugen sowohl das gesamte weitere Spulensystem als auch beide Teilspulensysteme eine gewisse Feldstärke ($\left| g_C^{eff,diamag} \right| > 0.1 mT/A$ , $\left| g_{C1}^{eff,diamag} \right| > 0.1 mT/A$ , $\left| g_{C2}^{eff,diamag} \right| > 0.1 mT/A$), wobei die Teilspulensysteme für sich alleine betrachtet eine Hysterese aufweisen (d.h. $\dfrac{g_{C1}^{eff,class}}{g_{C1}^{eff,diamag}} \notin [0.95,1.05]$,

$\dfrac{g_{C2}^{eff,class}}{g_{C2}^{eff,diamag}} \notin [0.95,1.05]$ ). Innerhalb des weiteren Spulensystems findet eine Kompensation von nicht verschwindenden Hystereseeffekten der einzelnen Teilspulensysteme statt. Kalibrierungen und Korrekturen werden somit überflüssig. Bei dem zweiten weiteren Teilspulensystem handelt es sich nicht um ein Modulationsspulensystem, sondern um ein weiteres Spulensystem, das zusammen mit dem ersten Teilspulensystem sowohl für die Felderzeugung als auch für die Feldänderung (Sweepen) zuständig ist. Die hierdurch realisierte Feldänderung erfolgt verglichen mit den von Modulationsspulen hervorgerufenen Feldänderungen langsam und weitestgehend linear. Durch das Vermeiden einer Hysterese im Spulensystem ist es möglich, mit der erfindungsgemäßen Magnetanordnung große Sweep-Bereiche zu fahren.

Besonders bevorzugt ist eine Ausführungsform der erfindungsgemäßen Vorrichtung, bei der sich $g_{C1}^{eff,diamag}$ und $g_{C2}^{eff,diamag}$ im Arbeitsvolumen konstruktiv überlagern, und bei der $\dfrac{g_{C1}^{eff,class}}{g_{C1}^{eff,diamag}} > 1.05$ und $\dfrac{g_{C2}^{eff,class}}{g_{C2}^{eff,diamag}} < 0.95$. Hierdurch kann die Feldeffizienz des weiteren Spulensystems im Arbeitsvolumen verbessert werden.

Eine alternative Ausführungsform sieht vor, dass sich $g_{C1}^{eff,diamag}$ und $g_{C2}^{eff,diamag}$ im Arbeitsvolumen destruktiv überlagern und dass $\dfrac{g_{C2}^{eff,class}}{g_{C2}^{eff,diamag}} \geq \dfrac{g_{C1}^{eff,class}}{g_{C1}^{eff,diamag}} > 1.05$ oder $\dfrac{g_{C2}^{eff,class}}{g_{C2}^{eff,diamag}} \leq \dfrac{g_{C1}^{eff,class}}{g_{C1}^{eff,diamag}} < 0.95$. Hierdurch wird eine höhere Flexibilität beim Design des weiteren Spulensystems ermöglicht.

Die erfindungsgemäße Vorrichtung ist besonders dann vorteilhaft, wenn für mindestens ein $i \in \{1,\ldots,n\}$ $\left| L_{C \to Ai}^{class} \right| < 0.01 \sqrt{L_{A,ii}^{class} \cdot L_C^{class}}$ gilt, wobei die genannten Größen folgende Bedeutung haben: $L_{A,ii}^{class}$ : Matrixelement in der i-ten Zeile und i-ten Spalte der Matrix $L_A^{class}$, $L_C^{class}$ : gesamte Induktivität des weiteren Spulensystems unter Vernachlässigung jeder diamagnetischen Verdrängung von Feldern aus dem Supraleitermaterial in der Magnetanordnung. In einer solchen Vorrichtung kann das Feld, welches durch das weitere Spulensystem erzeugt wird, variiert werden, ohne dass Stromänderungen in dem i-ten Strompfad des Magnetspulensystems induziert werden.

Besonders vorteilhaft ist auch eine Ausführungsform der erfindungsgemäßen Vorrichtung, bei der mindestens eine Spule des ersten Teilspulensystems und eine Spule des zweiten Teilspulensystems auf zwei unterschiedlichen Radien gewickelt sind. Die Flexibilität beim Design des weiteren Spulensystems ist dann besonders groß.

Eine weitere vorteilhafte Ausführungsform der erfindungsgemäßen Vorrichtung zeichnet sich dadurch aus, dass mindestens eine Spule des ersten Teilspulensystems und eine Spule des zweiten Teilspulensystems unterschiedliche Polaritäten aufweisen. In einer solchen Ausführungsform kann das weitere Spulensystem besonders effizient dimensioniert werden.

Besonders bevorzugt ist eine Ausführungsform der erfindungsgemäßen Magnetanordnung, bei der das Magnetspulensystem eine aktive Abschirmung umfasst. Hiermit wird für optimale Unterdrückung des Streufeldes des Magnetspulensystems gesorgt. Aufgrund der großen technischen Bedeutung von aktiv abgeschirmten Magneten ist es ein großer Vorteil, dass auch in solchen Magneten das weitere Spulensystem so dimensioniert werden kann, dass es hysteresenfrei wird.

Die erfindungsgemäße Vorrichtung ist besonders vorteilhaft, wenn das weitere Spulensystem im Arbeitsvolumen ein Feld erzeugt, welches in Überlagerung mit dem Feld des Magnetspulensystems dessen Inhomogenität um höchstens einen Faktor 2 vergrößert. Somit wird die Homogenität des Gesamtmagnetfeldes im Arbeitsvolumen, welches durch das Magnetspulensystem und das weitere Spulensystem erzeugt wird, beim Einfahren eines Stroms in das weitere Spulensystem nur minimal beeinflusst.

Vorzugsweise umfasst das weitere Spulensystem oder die Magnetteilspulensysteme Formkörper, die aus einem Material mit einer Resistivität > 1 E-9 Ohm m bei der Betriebstemperatur der Magnetanordnung bestehen. Bei Änderungen des Magnetfeldes werden Wirbelströme im Formkörper erzeugt. Wenn der Formkörper aus einem Material mit hoher Resistivität besteht, sind diese Ströme klein und beeinflussen das Feld im Arbeitsvolumen nur minimal.

Besonders vorteilhaft ist auch eine Ausführungsform der erfindungsgemäßen Magnetanordnung, bei der das erste Teilspulensystem oder das zweite Teilspulensystem mindestens eine Spule umfasst, die normalleitend ist. Der Vorteil dieser Anordnung besteht darin, dass die normalleitende Spule im Raumtemperaturbereich des Magnetspulensystems angebracht werden kann und daher die Kühlung des supraleitenden Teils der Magnetanordnung nicht beeinflusst. Normalleitende Materialien sind zudem billiger als supraleitende.

Da supraleitende Spulen größere Felder erzeugen können als normalleitende, kann es jedoch auch vorteilhaft sein, wenn das erste Teilspulensystem oder das zweite Teilspulensystem mindestens eine Spule umfasst, die supraleitend ist.

Bei einer Weiterbildung dieser Ausführungsform sind das Magnetspulensystem und das weitere Spulensystem in einem gemeinsamen Behälter angeordnet, wobei der Behälter mit Kühlflüssigkeiten gefüllt ist und/oder eine Vorrichtung zur aktiven Kühlung des Behälters vorgesehen ist. Dies ist die einfachste Ausführungsform für ein Magnetspulensystem und ein weiteres Spulensystem, welche aufgrund ihrer supraleitenden Eigenschaften auf einer tiefen Temperatur gehalten werden müssen.

Alternativ hierzu kann es auch vorteilhaft sein, wenn das Magnetspulensystem und das weitere Spulensystem in unterschiedlichen Behältern angeordnet sind, wobei die Behälter mit Kühlflüssigkeiten gefüllt sind und/oder eine Vorrichtung zur aktiven Kühlung der Behälter vorgesehen ist. Der Vorteil einer solchen Anordnung ist, dass unterschiedliche Temperaturen und Kühlleistungen für die beiden Behälter verwendet werden können.

Die erfindungsgemäße Magnetanordnung findet vorzugsweise als Teil einer Apparatur für Elektron-Paramagnetische Resonanz (=EPR) oder für Kernspin Resonanz (=NMR) Anwendung. Insbesondere bei der EPR kommen die Vorteile der erfindungsgemäßen Magnetanordnung zum Tragen, da hier das Durchfahren in einen großen Frequenzbereich vorteilhaft ist.

Bei der erfindungsgemäßen Magnetanordnung werden Hystereseeffekte eines klassisch konzipierten ersten Teilspulensystems durch das Zusammenspiel mit einem weiteren Teilspulensystem kompensiert. Beim Design des ersten Teilspulensystems muss daher wenig Rücksicht auf Hyteresenfreiheit genommen werden. Hierdurch ergibt sich eine Lösung des langjährigen Hysteresenproblems.

Die Erfindung betrifft darüber hinaus ein Verfahren zum Betrieb der erfindungsgemäßen Magnetanordnung, wobei mit mindestens einem der Magnetteilspulensysteme im Arbeitsvolumen ein Magnetfeld von mindestens 1 T erzeugt wird und wobei durch Änderung des Stroms, der im weiteren Spulensystem fliesst, das Gesamtmagnetfeld im Arbeitsvolumen, welches durch die Magnetteilspulensysteme und das weitere Spulensystem erzeugt wird, variiert wird.

Weitere Vorteile der Erfindung ergeben sich aus der Beschreibung und der Zeichnung.

Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

**Fig. 1:** einen schematischen Vertikalschnitt durch eine radiale Hälfte einer Ausführungsform der erfindungsgemäßen Magnetanordnung;

**Fig. 2:** einen schematischen Vertikalschnitt durch eine radiale Hälfte einer weiteren Ausführungsform der erfindungsgemäßen Magnetanordnung;

**Fig. 3:** einen schematischen Vertikalschnitt durch eine radiale Hälfte einer weiteren Ausführungsform der erfindungsgemäßen Magnetanordnung; und

**Fig. 4:** ein Verdrahtungsschema einer erfindungsgemäßen Magnetanordnung.

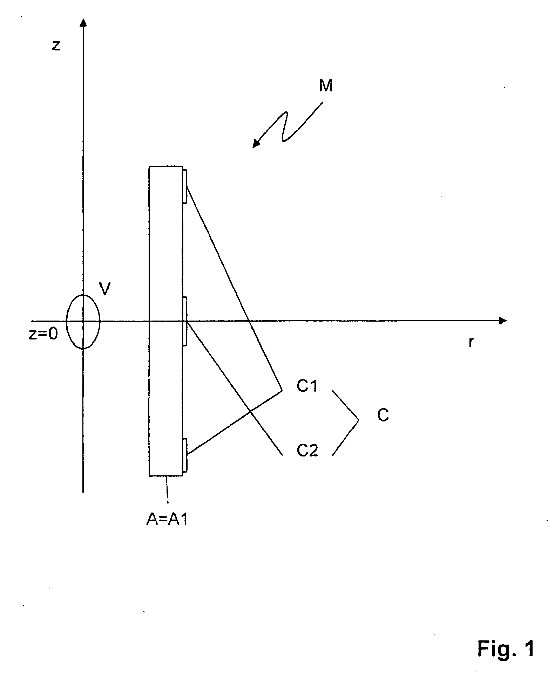

In **Fig. 1** ist eine erste Ausführungsform einer erfindungsgemäßen Magnetanordnung **M** mit einem Magnetspulensystem **A** und einem weiteren Spulensystem **C** um ein Arbeitsvolumen **V** gezeigt. Das Magnetspulensystem A umfasst in dieser Ausführungsform ein Magnetteilspulensystem A1 mit lediglich einer Spule. Das weitere Spulensystem C umfasst ein erstes Teilspulensystem **C1** mit zwei Spulen und ein zweites Teilspulensystem **C2** mit einer Spule, wobei die Teilspulensysteme C1, C2 auf der Spule des Magnetspulensystems A gewickelt sind. Damit das weitere Spulensystem C hysteresenfrei und vom Magnetspulensystem A entkoppelt ist, haben die zwei Spulen des ersten Teilspulensystems C1 bezüglich der Spule des zweiten Teilspulensystems C2 die entgegengesetzte Polarität.

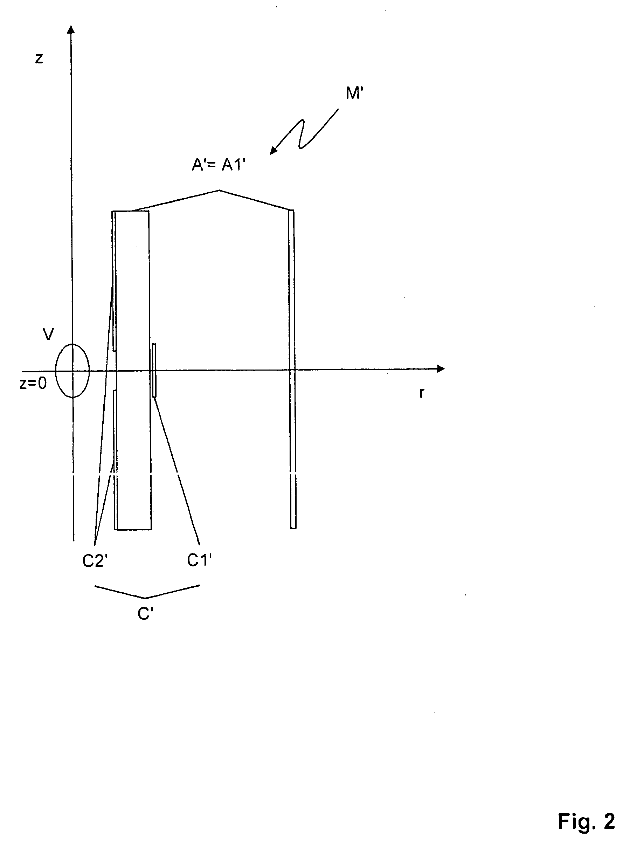

Eine weitere Ausführungsform einer erfindungsgemäßen Magnetanordnung **M'** ist in der **Fig. 2** gezeigt. Ein Magnetspulensystem A' umfasst ein Magnetteilspulensystem **A1'** und ist aktiv abgeschirmt. Die zwei Spulen des Magnetteilspulensystem A1' weisen also entgegengesetzte Polaritäten auf. Ein weiteres Spulensystem **C'** umfasst ein erstes und ein zweites Teilspulensystem C1', C2', wobei das erste Teilspulensystem C1' eine Spule und das zweite Teilspulensystem C2' zwei Spulen umfasst. Die Spule des ersten Teilspulensystems C1' und die Spulen des zweiten Teilspulensystems C2' sind auf zwei unterschiedlichen Radien gewickelt. Alle Spulen des weiteren Spulensystems C' haben die gleiche Polarität.

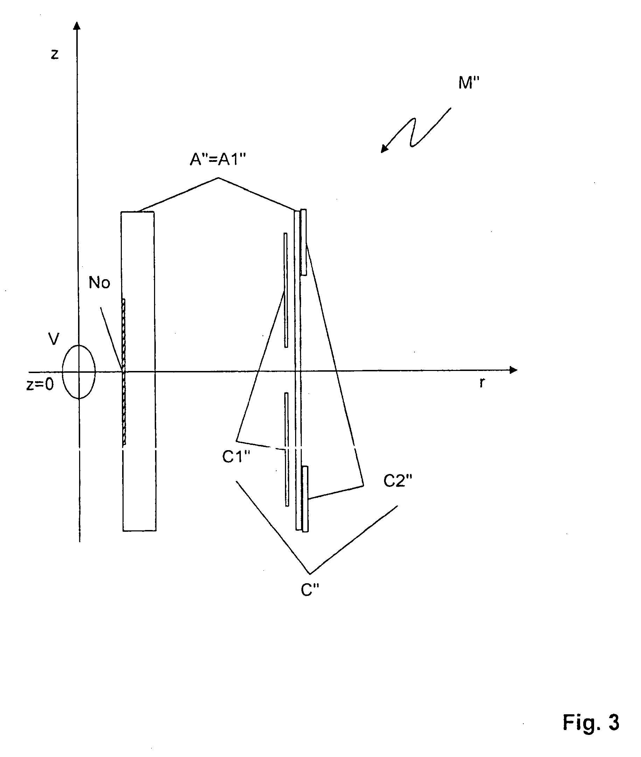

Eine weitere Ausführungsform einer erfindungsgemäßen Magnetanordnung **M"** ist in der **Fig. 3** gezeigt. Das Magnetspulensystem **A"** ist auch hier aktiv abgeschirmt und mit einem Full Notch **No** in der radial inneren Spule homogenisiert. Ein weiteres Spulensystem **C"** umfasst ein erstes und ein zweites Teilspulensystem **C1", C2",** wobei das erste Teilspulensystem C1" und das zweite Teilspulensystem C2" je zwei Spulen umfassen. Das erste und das zweite Teilspulensystem C1", C2" haben unterschiedliche Polaritäten.

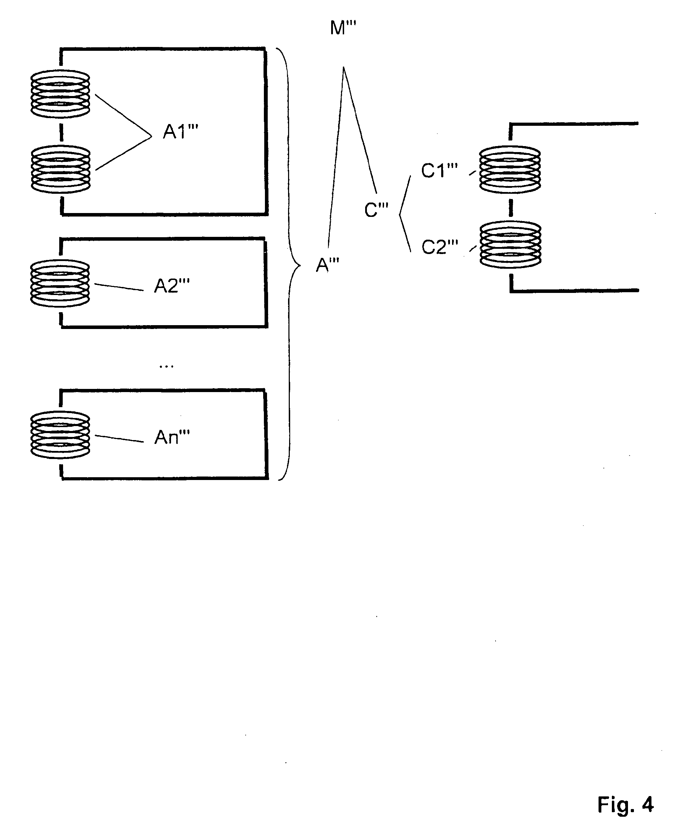

In **Fig. 4** ist die Verdrahtung einer erfindungsgemäßen Magnetanordnung **M'''** schematisch dargestellt. Ein Magnetspulensystem **A'''** umfasst hier n supraleitende Magnetteilspulensysteme **A1''', A2''', ... An''',** welche im Betriebszustand je supraleitend kurzgeschlossene Strompfade bilden. Das weitere Spulensystem **C'''** umfasst ein erstes und ein zweites Teilspulensystem **C1''', C2''',** die mindestens je eine Spule umfassen, und kann unabhängig vom Magnetspulensystem A''' geladen oder entladen werden.

Im Kapitel 7 von [5] wird der so genannte kritische Zustand von Typ II Supraleitern beschrieben. Typ II Supraleiter werden typischerweise im Magnetspulensystem A, A', A", A''' verwendet, da sie zur Erzeugung von hohen Magnetfeldern besonders geeignet sind. Diese Supraleiter sind oberhalb des unteren kritischen Magnetfeldes Bc1, welches in der Größenordnung von 0.1 Tesla liegt, im kritischen Zustand. In diesem Zustand wird jede kleine Magnetfeldänderung aus dem Supraleitervolumen verdrängt, indem Abschirmströme an der Oberfläche des Supraleitervolumens fließen. Makroskopisch gesehen verhält sich das Magnetspulensystem A, A', A", A''' also diamagnetisch, d. h. wie ein Material mit einer magnetischen Permeabilität, welche zwischen 0 und 1 liegt. Der genaue Wert der magnetischen Permeabilität ergibt sich aus dem Supraleiteranteil im Volumen des Magnetspulensystems M, M', M", M'''. Bei hohem Supraleiteranteil ist die magnetische Permeabilität in der Nähe von 0, bei niedrigem Supraleiteranteil in der Nähe von 1. Die erwähnte kleine Magnetfeldänderung kann durch eine Stromänderung im weiteren Spulensystem C, C', C", C''' erzeugt werden. Will man berechnen, welche Feldänderung im Arbeitsvolumen V durch eine kleine Stromänderung im weiteren Spulensystem C, C', C", C''' resultiert, darf die diamagnetische Eigenschaft des Magnetspulensystems A, A', A", A''' nicht außer Acht gelassen werden. Es ist die Formel

$$g_C^{eff,diamag} = g_C - g_A^{\mathrm{T}} \cdot \left( L_A^{diamag} \right)^{-1} \cdot L_{C \to A}^{diamag} + g_M$$

zu verwenden, wobei die verwendeten Größen die oben genannten Bedeutungen haben. In dieser Formel sind alle Größen g als Magnetfeld im Arbeitsvolumen V pro Ampere Strom im weiteren Spulensystem C, C', C", C''' zu verstehen. Der erste Term auf der rechten Seite wäre das Feld des weiteren Spulensystems C, C', C", C''' in Abwesenheit des Magnetspulensystems A, A', A", A'''. Der zweite Term ist der Feldbeitrag durch Stromänderungen im Magnetspulensystem A, A', A", A'''. Diese Stromänderungen kommen dadurch zustande, dass der magnetische Fluss infolge der Lenz'schen Regel vom supraleitenden Magnetspulensystem A, A', A", A''' konstant gehalten wird. Ihre Größe wird durch das diamagnetische Verhalten des Magnetspulensystems A, A', A", A''' beeinflusst. Der dritte Term ist schließlich der Feldbeitrag im Arbeitsvolumen V, der durch die Magnetisierung des Supraleiters des Magnetspulensystems A, A', A", A''' und des Spulensystems C, C', C", C''' zustande kommt. Die gesamte Feldänderung im Arbeitsvolumen V pro Ampere Strom im weiteren Spulensystem C, C', C", C''' ist also gegeben durch $g_C^{eff,diamag}$. Dies gilt allerdings nur für kleine Stromänderungen im weiteren Spulensystem C, C', C", C''', so dass $g_C^{eff,diamag}$ lediglich als Anfangswert der Feldänderung-pro-Ampere-Kurve zu verstehen ist. Ab einem gewissen Strom im weiteren Spulensystem C, C', C", C''' kann dieses unter Umständen in ein anderes "Regime" der Feldänderung-pro-Ampere-Kurve übergehen.

Je größer die Magnetfeldänderung nämlich ist, der ein Supraleiter ausgesetzt ist, umso mehr wird dieses Magnetfeld in das supraleitende Volumen eindringen. Ist die Magnetfeldänderung groß genug, wird jede zusätzliche Magnetfeldänderung voll in das supraleitende Volumen eindringen, so dass das Magnetspulensystem A, A', A", A''' eine magnetische Permeabilität von 1 aufweist. Man spricht dann vom klassischen Regime. Das Magnetfeld im Arbeitsvolumen V pro Ampère Strom im weiteren Spulensystem C, C', C", C''' berechnet sich dann mit der Formel

$$g_C^{eff,class} = g_C - g_A^{\mathrm{T}} \cdot \left( L_A^{class} \right)^{-1} \cdot L_{C \to A}^{class},$$

wobei alle Größen die gleiche Bedeutung haben wie die entsprechenden "diamagnetischen Größen", nur mit einer magnetischen Permeabilität von 1 für das Magnetspulensystem A, A', A", A'''. Die Größe $g_C^{eff,class}$ ist als Endwert der Feldänderung-pro-Ampere-Kurve des weiteren Spulensystems C, C', C", C''' zu interpretieren, also als Magnetfeldänderung pro Ampere Strom im weiteren Spulensystem C, C', C", C''', wenn vorgängig bereits eine große Magnetfeldänderung stattgefunden hat.

Bei jedem Vorzeichenwechsel der Stromänderung im weiteren Spulensystem C, C', C", C''' fällt man so lange in das diamagnetische Regime zurück, bis die Feldänderung im Magnetspulensystem A, A', A", A''' so groß ist, dass sie wieder in das supraleitende Volumen eindringen kann. Unterscheiden sich nun die Größen $g_C^{eff,diamag}$ und $g_C^{eff,class}$ voneinander, bekommt man eine nichtlineare Abhängigkeit der Feldänderung im Arbeitsvolumen V von der Stromänderung im weiteren Spulensystem C, C', C", C''', was in der Regel unerwünscht ist. Ziel der vorliegenden Erfindung ist es, die Größen $g_C^{eff,diamag}$ und $g_C^{eff,class}$ einander anzugleichen, damit die Feld-Strom Abhängigkeit möglichst linear wird.

Im Folgenden wird die Erfindung anhand der in den Fig. 1 bis 3 gezeigten Ausführungsformen einer supraleitenden Magnetanordnung erläutert, welche ein supraleitendes Magnetspulensystem A, A', A" und ein weiteres Spulensystem C, C', C" zur Erzeugung eines Magnetfeldes im Arbeitsvolumen V umfassen, wobei das weitere Spulensystem C, C', C" jeweils unabhängig vom Magnetspulensystem A, A', A" geladen oder entladen werden kann.

In der in Fig. 1 gezeigten ersten Ausführungsform (im Weiterem "AF1" genannt) umfasst das Magnetspulensystem A nur eine Spule. Das weitere Spulensystem C umfasst ein erstes und ein zweites Teilspulensystem C1, C2, wobei das erste Teilspulensystem C1 zwei Spulen und das zweite Teilspulensystem C2 nur eine Spule umfasst. Alle Spulen des weiteren Spulensystems C sind miteinander in Serie geschaltet und auf der Spule des Magnetspulensystems A angebracht. Die zwei Spulen des ersten Teilspulensystems C1 und die Spule des zweiten Teilspulensystems C2 haben entgegengesetzte Polaritäten. $g_{C1}^{eff,diamag}$ und $g_{C2}^{eff,diamag}$ überlagern sich im Arbeitsvolumen V konstruktiv. Es gelten die Ungleichungen $\dfrac{g_{C1}^{eff,class}}{g_{C1}^{eff,diamag}} > 1.05$ , $\dfrac{g_{C2}^{eff,class}}{g_{C2}^{eff,diamag}} < 0.95$ und $\dfrac{g_C^{eff,class}}{g_C^{eff,diamag}} = 0.99$ .

In der in Fig. 2 gezeigten zweiten Ausführungsform (im Weiterem **"AF2"** genannt) ist das Magnetspulensystem A' aktiv abgeschirmt und umfasst zwei Spulen. Das weitere Spulensystem C' umfasst ein erstes und ein zweites Teilspulensystem C1', C2', wobei das erste Teilspulensystem C1' eine Spule und das zweite Teilspulensystem C2' zwei Spulen umfasst. Die Spule des ersten Teilspulensystems C1' und die Spulen des zweiten Teilspulensystems C2' sind auf zwei unterschiedlichen Radien gewickelt und haben die gleiche Polarität. Die Spulen des weiteren Spulensystems C' sind so angeordnet, dass sich $g_{C1}^{eff,diamag}$ und $g_{C2}^{eff,diamag}$ im Arbeitsvolumen V destruktiv überlagern, also

$$\frac{g_{C2}^{eff,class}}{g_{C2}^{eff,diamag}} \le \frac{g_{C1}^{eff,class}}{g_{C1}^{eff,diamag}} < 0.95$$

und

$$\frac{g_C^{eff,class}}{g_C^{eff,diamag}} = 0.96 .$$

In der in Fig. 3 gezeigten dritten Ausführungsform (im Weiterem "AF3" genannt) ist das Magnetspulensystem A" wie in AF2 aktiv abgeschirmt. In dieser Ausführungsform ist das Magnetspulensystem A" mit einem Full Notch No in der ersten Spule homogenisiert. Das erste und das zweite Teilspulensystem C1", C2" des weiteren Spulensystems C" umfassen je zwei Spulen. Die Spulen des ersten Teilspulensystems C1" und die Spulen des zweiten Teilspulensystems C2" sind auf zwei unterschiedlichen Radien gewickelt. Die Spulen des ersten Teilspulensystems C1" und die Spulen des zweiten Teilspulensystems C2" haben entgegengesetzte Polaritäten, so dass sich $g_{C1}^{eff,diamag}$ und $g_{C2}^{eff,diamag}$ im Arbeitsvolumen V destruktiv überlagern d.h. $\dfrac{g_{C2}^{eff,class}}{g_{C2}^{eff,diamag}} \le \dfrac{g_{C1}^{eff,class}}{g_{C1}^{eff,diamag}} < 0.95$ und das weitere Spulen-

system C" hysteresenfrei wird $(\frac{g_C^{eff,class}}{g_C^{eff,diamag}} = 1.00)$. Die Geometrie der Spulen wurde so gewählt, dass das weitere Spulensystem C" im Arbeitsvolumen V ein Feld erzeugt, welches in Überlagerung mit dem Feld des Magnetspulensystems A" dessen Inhomogenität in einem Kugel-Volumen mit 40mm Durchmesser um einen Faktor kleiner als 2 vergrößert für +/-10A im weiteren Spulensystem C". Das weitere Spulensystem C" ist also auch homogen.

Tabelle 1 zeigt die geometrischen Maße der Spulen der Ausführungsform AF1.

| Tabelle 1 - AF1 | | ri [mm] | ra [mm] | L [mm] | O [mm] | N | W |
|---|---|---|---|---|---|---|---|
| A | Erste Spule | 59.3 | 89.7 | 286.0 | 0.0 | 50 | 409.2 |
| C1 | Erste Spule | 89.7 | 93.4 | 31.0 | 125.5 | 6 | 44.4 |
| | Zweite Spule | 89.7 | 93.4 | 31.0 | -125.5 | 6 | 44.4 |
| C2 | Erste Spule | 89.7 | 93.4 | 45.0 | 0.0 | 6 | -63.4 |

Tabelle 2 zeigt die geometrischen Masse der Spulen der Ausführungsform AF2.

| Tabelle 2 - AF2 | | ri [mm] | ra [mm] | L [mm] | O [mm] | N | W |
|---|---|---|---|---|---|---|---|
| A' | Erste Spule | 40.0 | 69.2 | 300.0 | 0.0 | 48 | 429.2 |
| | Zweite Spule | 130.0 | 134.9 | 300.0 | 0.0 | 8 | -429.2 |
| C1' | Erste Spule | 69.2 | 70.5 | 50.0 | 0.0 | 2 | 71.5 |
| C2' | Erste Spule | 38.7 | 40.0 | 120.0 | 90.0 | 2 | 171.7 |
| | Zweite Spule | 38.7 | 40.0 | 120.0 | -90.0 | 2 | 171.7 |

Tabelle 3 zeigt die geometrischen Masse der Spulen der Ausführungsform AF3.

| Tabelle 3 - AF3 | | ri [mm] | ra [mm] | L [mm] | O [mm] | N | W |
|---|---|---|---|---|---|---|---|
| A" | Erste Spule | 40.0 | 69.2 | 300.0 | 0.0 | 48 | 429.2 |
| | Full Notch | 40.0 | 42.5 | 137.0 | 0.0 | 4 | - |
| | Zweite Spule | 130.0 | 134.9 | 300.0 | 0.0 | 8 | -429.2 |
| C1" | Erste Spule | 120.0 | 122.5 | 107.0 | 74.5 | 4 | 153.1 |
| | Zweite Spule | 120.0 | 122.5 | 107.0 | -74.5 | 4 | 153.1 |
| C2" | Erste Spule | 135.0 | 139.9 | 62.0 | 121.5 | 8 | -88.7 |
| | Zweite Spule | 135.0 | 139.9 | 62.0 | -121.5 | 8 | -88.7 |

Dabei bedeuten für jede Spule jeweils ri: Innenradius, ra: Außenradius, L: Ausdehnung in Magnetachsenrichtung z, O: z-Koordinate der Spulenmitte, N: Anzahl Drahtlagen und W die Anzahl Windungen pro Drahtlage. W ist jeweils mit einem Vorzeichen behaftet, das die Polarität, d.h. die Stromrichtung, der entsprechenden Spule wiedergibt.
Für die drei Ausführungsformen AF1, AF2 und AF3 zeigt die Tabelle 4 die Faktoren $g_A$ des Magnetspulensystems A, A', A" und $g_{C1}$, $g_{C2}$, $g_C$, des ersten und des zweiten Teilspulensystems C1, C2, C1' C2', C1", C2" des weiteren Spulensystems C, C', C". Die berechneten Faktoren $g_{C1}^{eff,diamag}$ , $g_{C2}^{eff,diamag}$ $g_C^{eff,diamag}$ , $\frac{g_{C1}^{eff,class}}{g_{C1}^{eff,diamag}}$ $\frac{g_{C2}^{eff,class}}{g_{C2}^{eff,diamag}}$

und $\frac{g_C^{eff,class}}{g_C^{eff,diamag}}$ des ersten und des zweiten Teilspulensystems C1, C2, C1' C2', C1", C2" des weiteren Spulensystems C, C', C" sind in der Tabelle 4 auch aufgelistet.

Tabelle 4

| Tabelle 4 | AF1 | AF2 | AF3 |
|---|---|---|---|
| $g_A$ [mT/A] | 73.14 | 70.24 | 64.08 |
| $g_{C1}$ [mT/A] | -0.76 | 1.21 | 3.99 |
| $g_{C2}$ [mT/A] | 2.54 | 1.30 | -2.77 |
| $g_C$ [mT/A] | 1.78 | 2.51 | 1.22 |
| $g_{C1}^{eff,diamag}$ [mT/A] | 0.98 | 0.68 | 3.93 |
| $g_{C2}^{eff,diamag}$ [mT/A] | 0.78 | -0.20 | -3.74 |
| $g_C^{eff,diamag}$ [mT/A] | 1.77 | 0.48 | 0.19 |
| $\dfrac{g_{C1}^{eff,class}}{g_{C1}^{eff,diamag}}$ | 1.09 | 0.92 | 0.83 |
| $\dfrac{g_{C2}^{eff,class}}{g_{C2}^{eff,diamag}}$ | 0.87 | 0.82 | 0.82 |
| $\dfrac{g_C^{eff,class}}{g_C^{eff,diamag}}$ | 0.99 | 0.96 | 1.00 |

Diese Werte können beispielsweise mit Hilfe einer Finite Elemente Software ermittelt werden. Im Falle der Größen mit einem Index "class" werden sowohl der Luft wie auch den Spulen eine magnetische Permeabilität von 1 zugewiesen. Bei den Größen mit einem Index "diamag" wurden hingegen in der Berechnung die Spulen des Magnetspulensystems A, A', A" mit einer Permeabilität von 0.5 versehen, während alle anderen Spulen und die Luft unverändert eine Permeabilität von 1 aufwiesen. Diese Permeabilität von 0.5 berücksichtigt die Tatsache, dass kleine Magnetfeldänderungen aus dem Volumen des Magnetspulensystems A, A', A" verdrängt werden. Da der Supraleiter nicht das ganze Volumen des Magnetspulensystems A, A', A" abdeckt, findet nur eine unvollständige Verdrängung statt. Die Permeabilität liegt deshalb im Intervall [0,1] (0=vollständige Verdrängung, 1 =keine Verdrängung).

Die in den Figuren beispielhaft gezeigten sowie weitere erfindungsgemäße Ausführungsformen kann der Fachmann unter Verwendung von üblichen Optimierungsverfahren, bei welchen die Spulenkonfigurationen so lange variiert werden, bis das Kriterium als Zielfunktion des Optimierungsverfahrens erfüllt ist, aus den oben genannten Bedingungen für die Größen $g_{C1}^{eff,diamag}$ , $g_{C2}^{eff,diamag}$ , $g_{C1}^{eff,class}$ , $g_{C2}^{eff,class}$ , $g_C^{eff,diamag}$ . $g_C^{eff,class}$ erhalten.

Bezugszeichenliste

| A, A', A", A''' | Magnetspulensystem |
|---|---|
| A1, A1', A1", A1''', A2''', An''' | Magnetteilspulensysteme |
| n | Anzahl der Magnetteilspulensysteme des Magnetspulensystems |
| C, C', C", C''' | Weiteres Spulensystem |
| C1, C1', C1", C1''' | Erstes Teilspulensystem |
| C2, C2', C2", C2''' | Zweites Teilspulensystem |
| L | Axiale Länge einer Spule |
| M, M', M", M''' | Magnetanordnung |
| N | Anzahl Lagen einer Spule |
| No | Full Notch |

| O | z-Koordinate des Zentrums einer Spule |
|---|---|
| ri | Innenradius eine Spule |
| ra | Außenradius einer Spule |
| V | Arbeitsvolumen |
| W | Anzahl Windungen pro Lage einer Spule |

Referenzliste

[1] M.J. Nilges et al., Appl. Mag. Reson. 16, 167-183 (1999).

[2] G.M. Smith, P.C. Riedi, "Progress in high field EPR", Royal Society of Chemistry Specialist Periodical Reports 17, (2000).

[3] Poster Webseite Cryogenic (www.cryogenic.co.uk/media/products/cf systems/EPR.pdf).

[4] DE10041672.

[5] M.N. Wilson, "Superconducting Magnets", Oxford University Press, New York (1983).

[6] D. Schmalbein et al., Appl. Mag. Reson. 16, 185-205 (1999).

[7] M.R. Fuchs, Diss. FU Berlin (2000).

[8] A.F. Gullä et al., Concepts in Magnetic Resonance 15, 201-207 (2002).

**Patentansprüche**

1. Magnetanordnung (M, M', M'', M''') zur Erzeugung eines Magnetfeldes in Richtung einer z-Achse in einem auf der z-Achse um z=0 angeordneten Arbeitsvolumen (V) mit einem Magnetspulensystem (A, A', A'', A'''), welches ein oder mehrere supraleitende Magnetteilspulensysteme (A1, A1', A1'', A1''', A2''', ..., An''') umfasst, welche im Betriebszustand je supraleitend kurzgeschlossene Strompfade bilden, wobei das Magnetspulensystem (A, A', A'', A''') Typ-2-Supraleitermaterial umfasst, welches sich im Betriebszustand in einem Magnetfeld oberhalb seiner unteren kritischen Kraftflussdichte befindet, und mit einem weiteren Spulensystem (C, C', C'', C''') zur Erzeugung einer Magnetfeldänderung, welches unabhängig vom Magnetspulensystem (A, A', A'', A''') geladen oder entladen werden kann, und welches ein erstes und ein zweites Teilspulensystem (C1, C2, C1' C2', C1'', C2'', C1''', C2''') umfasst, wobei das erste Teilspulensystem (C1, C1', C1'', C1''') und das zweite Teilspulensystem (C2, C2', C2'', C2''') mindestens je eine Spule umfassen, wobei alle Spulen des weiteren Spulensystems (C, C', C'', C''') miteinander in Serie geschaltet sind, wobei $\left| g_C^{eff,diamag} \right| > 0.1 mT/A$,

**dadurch gekennzeichnet,**
**dass** das Magnetspulensystem (A, A', A'', A''') und das erste und das zweite Teilspulensystem (C1, C2, C1' C2', C1'', C2'', C1''', C2''') so eingerichtet sind, dass

$$\left| g_{C1}^{eff,diamag} \right| > 0.1 mT/A \, , \quad \left| g_{C2}^{eff,diamag} \right| > 0.1 mT/A \, ,$$

$$\frac{g_{C1}^{eff,class}}{g_{C1}^{eff,diamag}} \notin [0.95, 1.05] \, , \quad \frac{g_{C2}^{eff,class}}{g_{C2}^{eff,diamag}} \notin [0.95, 1.05] \, ,$$

und

$$\frac{g_C^{eff,class}}{g_C^{eff,diamag}} \in [0.95, 1.05],$$

mit

$$g_C^{eff,class} = g_C - g_A^{\mathsf{T}} \cdot \left(L_A^{class}\right)^{-1} \cdot L_{C \to A}^{class},$$

$$g_{C1}^{eff,class} = g_{C1} - g_A^{\mathsf{T}} \cdot \left(L_A^{class}\right)^{-1} \cdot L_{C1 \to A}^{class},$$

$$g_{C2}^{eff,class} = g_{C2} - g_A^{\mathsf{T}} \cdot \left(L_A^{class}\right)^{-1} \cdot L_{C2 \to A}^{class},$$

$$g_C^{eff,diamag} = g_C - g_A^{\mathsf{T}} \cdot \left(L_A^{diamag}\right)^{-1} \cdot L_{C \to A}^{diamag} + g_M,$$

$$g_{C1}^{eff,diamag} = g_{C1} - g_A^{\mathsf{T}} \cdot \left(L_A^{diamag}\right)^{-1} \cdot L_{C1 \to A}^{diamag} + g_{M1},$$

$$g_{C2}^{eff,diamag} = g_{C2} - g_A^{\mathsf{T}} \cdot \left(L_A^{diamag}\right)^{-1} \cdot L_{C2 \to A}^{diamag} + g_{M2}$$

mit:

$g_C$, $g_{C1}$, $g_{C2}$: Feld pro Ampere Strom des weiteren Spulensystems (C, C', C", C''') bzw. des ersten oder zweiten Teilspulensystems (C1, C2, C1' C2', C1", C2", C1''', C2''') im Arbeitsvolumen (V) ohne die Feldbeiträge der Magnetteilspulensysteme (A1, A1', A1", A1''', A2''', .... An''') und ohne den Feldbeitrag der Magnetisierung von Supraleitermaterial in der Magnetanordnung (M, M', M", M'''),

$$g_A^{\mathsf{T}} = (g_{A1}, \ldots, g_{Aj}, \ldots g_{An}),$$

$g_{Aj}$: Feld pro Ampere Strom des j-ten Magnetteilspulensystems (Aj) im Arbeitsvolumen (V) ohne die Feldbeiträge der i-ten Magnetteilspulensysteme (Ai) für $i \neq j$ und ohne die Feldbeiträge des weiteren Spulensystems (C, C', C", C''') und der Magnetisierung von Supraleitermaterial in der Magnetanordnung (M, M', M", M'''),

$L_A^{class}$: n x n Matrix der Eigeninduktivitäten und der induktiven Kopplungen zwischen den Magnetteilspulensystemen (A1, A1', A1", A1''', A2''', ..., An'''), unter Vernachlässigung jeder diamagnetischen Verdrängung von Feldern aus dem Supraleitermaterial in der Magnetanordnung (M, M', M", M'''),

$$L_{C \to A}^{class} = \begin{pmatrix} L_{C \to A1}^{class} \\ \vdots \\ L_{C \to An}^{class} \end{pmatrix}, \quad L_{C1 \to A}^{class} = \begin{pmatrix} L_{C1 \to A1}^{class} \\ \vdots \\ L_{C1 \to An}^{class} \end{pmatrix}, \quad L_{C2 \to A}^{class} = \begin{pmatrix} L_{C2 \to A1}^{class} \\ \vdots \\ L_{C2 \to An}^{class} \end{pmatrix}$$

$L_{C \to Ai}^{class}$, $L_{C1 \to Ai}^{class}$, $L_{C2 \to Ai}^{class}$: Induktive Kopplungen des weiteren Spulensystems (C, C', C", C''') bzw. des ersten oder zweiten Teilspulensystems (C1, C2, C1' C2', C1", C2", C1"', C2"') mit dem i-ten Magnetteilspulensystem (Ai), unter Vernachlässigung jeder diamagnetischen Verdrängung von Feldern aus dem Supraleitermaterial in der Magnetanordnung (M, M', M", M"'),

$L_A^{diamag}$ : n x n Matrix der Eigeninduktivitäten und induktiven Kopplungen zwischen den Magnetteilspulensystemen (A1, A1', A1'', A1"', A2"', ..., An"') bei vollständiger diamagnetischer Verdrängung von Feldänderungen aus dem supraleitenden Materialanteil in der Magnetanordnung (M, M', M", M"')

$$L_{C \to A}^{diamag} = \begin{pmatrix} L_{C \to A1}^{diamag} \\ \vdots \\ L_{C \to An}^{diamag} \end{pmatrix}, \quad L_{C1 \to A}^{diamag} = \begin{pmatrix} L_{C1 \to A1}^{diamag} \\ \vdots \\ L_{C1 \to An}^{diamag} \end{pmatrix}, \quad L_{C2 \to A}^{diamag} = \begin{pmatrix} L_{C2 \to A1}^{diamag} \\ \vdots \\ L_{C2 \to An}^{diamag} \end{pmatrix}$$

$L_{C \to Ai}^{diamag}$, $L_{C1 \to Ai}^{diamag}$, $L_{C2 \to Ai}^{diamag}$ : Induktive Kopplungen des weiteren Spulensystems (C, C', C", C"') bzw. des ersten oder zweiten Teilspulensystems (C1, C2, C1' C2', C1", C2", C1"', C2"') mit dem i-ten Magnetteilspulensystem (Ai) bei vollständiger diamagnetischer Verdrängung von Feldänderungen aus dem supraleitenden Materialanteil in der Magnetanordnung (M, M', M", M"'), $g_M$, $g_{M1}$, $g_{M2}$ : Feld im Arbeitsvolumen (V), welches von der Magnetisierung von Supraleitermaterial in der Magnetanordnung (M, M', M", M"') bei einer Stromänderung von einem Ampere im weiteren Spulensystem (C, C', C", C"') bzw. im ersten oder zweiten Teilspulensystem (C1, C2, C1' C2', C1 ", C2", C1"', C2"') herrührt, bei vollständiger diamagnetischer Verdrängung von Feldänderungen aus dem supraleitenden Materialanteil in der Magnetanordnung (M, M', M", M"') und bei Berücksichtigung der induzierten Ströme in den Magnetteilspulensystemen (A1, A1', A1", A1"', A2"', ..., An"'), n: Anzahl der Magnetteilspulensysteme (A1, A1', A1", A1"', A2"', ..., An"') des Magnetspulensystems (A, A', A", A"').

**2.**

Magnetanordnung (M, M"') nach Anspruch 1, **dadurch gekennzeichnet, dass** sich $g_{C1}^{eff,diamag}$ und $g_{C2}^{eff,diamag}$ im Arbeitsvolumen (V) konstruktiv überlagern und dass $\dfrac{g_{C1}^{eff,class}}{g_{C1}^{eff,diamag}} > 1.05$ und $\dfrac{g_{C2}^{eff,class}}{g_{C2}^{eff,diamag}} < 0.95$ .

**3.**

Magnetanordnung (M', M", M"') nach Anspruch 1, **dadurch gekennzeichnet, dass** sich $g_{C1}^{eff,diamag}$ und $g_{C2}^{eff,diamag}$ im Arbeitsvolumen (V) destruktiv überlagern und dass

$$\frac{g_{C2}^{eff,class}}{g_{C2}^{eff,diamag}} \geq \frac{g_{C1}^{eff,class}}{g_{C1}^{eff,diamag}} > 1.05$$

oder

$$\frac{g_{C2}^{eff,class}}{g_{C2}^{eff,diamag}} \leq \frac{g_{C1}^{eff,class}}{g_{C1}^{eff,diamag}} < 0.95 .$$

**4.** Magnetanordnung (M, M"') nach einem der vorhergehenden Ansprüche, **dadurch gekennzeichnet, dass** für mindestens ein $i \in \{1,...,n\}$

$$\left| L_{C \to Ai}^{class} \right| < 0.01 \sqrt{L_{A,ii}^{class} \cdot L_C^{class}}$$

gilt mit:

$L_{A\,ii}^{class}$: Matrixelement in der i-ten Zeile und i-ten Spalte der Matrix $L_{A}^{class}$,

$L_{C}^{class}$: gesamte Induktivität des weiteren Spulensystems (C, C''') unter Vernachlässigung jeder diamagnetischen Verdrängung von Feldern aus dem Supraleitermaterial in der Magnetanordnung (M, M''').

5. Magnetanordnung (M', M'', M''') nach einem der vorhergehenden Ansprüche, **dadurch gekennzeichnet, dass** mindestens eine Spule des ersten Teilspulensystems (C1', C1'', C1''') und eine Spule des zweiten Teilspulensystems (C2', C2'', C2''') auf zwei unterschiedlichen Radien gewickelt sind.

6. Magnetanordnung (M, M'', M''') nach einem der vorhergehenden Ansprüche, **dadurch gekennzeichnet, dass** mindestens eine Spule des ersten Teilspulensystems (C1, C1'', C1''') und eine Spule des zweiten Teilspulensystems (C2, C2'', C2''') unterschiedliche Polaritäten aufweisen.

7. Magnetanordnung (M', M'', M''') nach einem der vorhergehenden Ansprüche, **dadurch gekennzeichnet, dass** das Magnetspulensystem (A', A'', A''') eine aktive Abschirmung umfasst.

8. Magnetanordnung (M'', M''') nach einem der vorhergehenden Ansprüche, **dadurch gekennzeichnet, dass** das weitere Spulensystem (C'', C''') dazu eingerichtet ist, im Arbeitsvolumen (V) ein Feld zu erzeugen, welches in Überlagerung mit dem Feld des Magnetspulensystems (A'', A''') dessen Inhomogenität um höchstens einen Faktor 2 vergrößert.

9. Magnetanordnung (M, M', M'', M''') nach einem der vorhergehenden Ansprüche, **dadurch gekennzeichnet, dass** das erste Teilspulensystem (C1, C1', C1'', C1''') oder das zweite Teilspulensystem (C2, C2', C2'', C2''') mindestens eine Spule umfasst, die normalleitend ist.

10. Magnetanordnung (M, M', M'', M''') nach einem der vorhergehenden Ansprüche, **dadurch gekennzeichnet, dass** das erste Teilspulensystem (C1, C1', C1'', C1''') oder das zweite Teilspulensystem (C2, C2', C2'', C2''') mindestens eine Spule umfasst, die supraleitend ist.

11. Magnetanordnung (M, M', M'', M''') nach Anspruch 10, **dadurch gekennzeichnet, dass** das Magnetspulensystem (A, A', A'', A''') und das weitere Spulensystem (C, C', C'', C''') in einem gemeinsamen Behälter angeordnet sind, wobei der Behälter zur Befüllung mit einer Kühlflüssigkeiten eingerichtet ist und/oder eine Vorrichtung zur aktiven Kühlung des Behälters vorgesehen ist.

12. Magnetanordnung (M, M', M'', M''') nach Anspruch 10, **dadurch gekennzeichnet, dass** das Magnetspulensystem (A, A', A'', A''') und das weitere Spulensystem (C, C', C'', C''') in unterschiedlichen Behältern angeordnet sind, wobei die Behälter zur Befüllung mit einer Kühlflüssigkeit eingerichtet sind und/oder eine Vorrichtung zur aktiven Kühlung der Behälter vorgesehen ist.

13. Magnetanordnung (M, M', M'', M''') nach einem der vorhergehenden Ansprüche, **dadurch gekennzeichnet, dass** die Magnetanordnung Teil einer Apparatur für Elektron-Paramagnetische Resonanz (=EPR) oder für Kernspin Resonanz (=NMR) ist.

14. Verfahren zum Betrieb einer Magnetanordnung (M, M', M'', M''') nach einem der vorhergehenden Ansprüche, **dadurch gekennzeichnet, dass** mit mindestens einem der Magnetteilspulensysteme (A1, A1', A1'', A1''', A2''', ..., An''') im Arbeitsvolumen (V) ein Magnetfeld von mindestens 1 T erzeugt wird und wobei durch Änderung des Stroms, der im weiteren Spulensystem (C, C', C'', C''') fliesst, das Gesamtmagnetfeld im Arbeitsvolumen (V), welches durch die Magnetteilspulensysteme (A1, A1', A1'', A1''', A2''', ..., An''') und das weitere Spulensystem (C, C', C'', C''') erzeugt wird, variiert wird.

## Claims

1. Magnet arrangement (M, M', M'', M''') for generating a magnetic field in the direction of a z-axis in a working volume (V) disposed on the z-axis about z=0, with a magnet coil system (A, A', A", A"') which comprises one or more superconducting magnet partial coil systems (A1, A1', A1", A1"', A2"', ..., An"'), each forming superconductingly shortcircuited current paths in the operating state, wherein the magnet coil system (A, A', A", A"') comprises a type 2 superconducting material which, in the operating state, is in a magnetic field above its lower critical flux density, and with a further coil system (C, C', C", C"') for inducing a magnetic field change, which can be charged or discharged independently of the magnet coil system (A, A', A", A"') and comprises a first and a second partial coil system (C1, C2, C1', C2', C1", C2", C1"', C2"'), wherein the first partial coil system (C1, C1', C1", C1"') and the second partial coil system (C2, C2', C2", C2"') each comprise at least one coil, wherein all coils of the further coil system (C, C', C", C"') are connected in series, wherein $g_C^{eff,diamag} > 0.1 mT / A$,

**characterized in that**

the magnet coil system (A, A', A", A"') and the first and the second partial coil system (C1, C2, C1', C2', C1", C2", C1"', C2"') are designed such that

$$g_{C1}^{eff,diamag} > 0.1 mT / A, \quad g_{C2}^{eff,diamag} > 0.1 mT / A,$$

$$\frac{g_{C1}^{eff,class}}{g_{C1}^{eff,diamag}} \notin [0.95, 1.05], \quad \frac{g_{C2}^{eff,class}}{g_{C2}^{eff,diamag}} \notin [0.95, 1.05],$$

and

$$\frac{g_C^{eff,class}}{g_C^{eff,diamag}} \in [0.95, 1.05],$$

with

$$g_C^{eff,class} = g_C - g_A^{\mathrm{T}} \cdot \left( L_A^{class} \right)^{-1} \cdot L_{C \to A}^{class},$$

$$g_{C1}^{eff,class} = g_{C1} - g_A^{\mathrm{T}} \cdot \left( L_A^{class} \right)^{-1} \cdot L_{C1 \to A}^{class},$$

$$g_{C2}^{eff,class} = g_{C2} - g_A^{\mathrm{T}} \cdot \left( L_A^{class} \right)^{-1} \cdot L_{C2 \to A}^{class},$$

$$g_C^{eff,diamag} = g_C - g_A^{\mathrm{T}} \cdot \left( L_A^{diamag} \right)^{-1} \cdot L_{C \to A}^{diamag} + g_M,$$

$$g_{C1}^{eff,diamag} = g_{C1} - g_A^{\mathrm{T}} \cdot \left( L_A^{diamag} \right)^{-1} \cdot L_{C1 \to A}^{diamag} + g_{M1},$$

$$g_{C2}^{eff,diamag} = g_{C2} - g_A^{\mathrm{T}} \cdot \left( L_A^{diamag} \right)^{-1} \cdot L_{C2 \to A}^{diamag} + g_{M2}$$

with:

$g_C, g_{C1}, g_{C2}$ : field per ampere current of the further coil system (C, C', C", C"') or of the first or second partial coil system (C1, C2, C1', C2', C1", C2", C1''', C2''') in the working volume (V) without the field contributions of the magnet partial coil systems (A1, A1', A1", A1''', A2''', ..., An''') and without the field contribution of the magnetization of superconductor material in the magnet arrangement (M, M', M", M'''), $g_A{}^T=(g_{A1},...,g_{Aj},...g_{An})$,

$g_{Aj}$ : field per ampere current of the j-th magnet partial coil system (Aj) in the working volume (V) without the field contributions of the i-th magnet partial coil systems (Ai) for $i \neq j$ and without the field contributions of the further coil system (C, C', C", C''') and the magnetization of superconductor material in the magnet arrangement (M, M', M", M'''),

$L_A^{class}$ : n x n matrix of the self-inductances and of the inductive couplings between the magnet partial coil systems (A1, A1', A1", A1''', A2''', ..., An'''), thereby neglecting any diamagnetic expulsion of fields from the superconductor material in the magnet arrangement (M, M', M", M'''),

$$L_{C \to A}^{class} = \begin{pmatrix} L_{C \to A1}^{class} \\ \vdots \\ L_{C \to An}^{class} \end{pmatrix}, \quad L_{C1 \to A}^{class} = \begin{pmatrix} L_{C1 \to A1}^{class} \\ \vdots \\ L_{C1 \to An}^{class} \end{pmatrix}, \quad L_{C2 \to A}^{class} = \begin{pmatrix} L_{C2 \to A1}^{class} \\ \vdots \\ L_{C2 \to An}^{class} \end{pmatrix}$$

$L_{C \to Ai}^{class}$ , $L_{C1 \to Ai}^{class}$ , $L_{C2 \to Ai}^{class}$ : inductive couplings of the further coil system (C, C', C", C''') or of the first or second partial coil system (C1, C2, C1' C2', C1", C2", C1''', C2''') with the i-th magnet partial coil system (Ai), thereby neglecting any diamagnetic expulsion of fields from the superconductor material in the magnet arrangement (M, M', M", M'''),

$L_A^{diamag}$ : n x n matrix of the self-inductances and of the inductive couplings between the magnet partial coil systems (A1, A1', A1", A1''', A2''', ..., An''') in case of complete diamagnetic expulsion of field changes from the superconducting material volume in the magnet arrangement (M, M', M", M'''),

$$L_{C \to A}^{diamag} = \begin{pmatrix} L_{C \to A1}^{diamag} \\ \vdots \\ L_{C \to An}^{diamag} \end{pmatrix}, \quad L_{C1 \to A}^{diamag} = \begin{pmatrix} L_{C1 \to A1}^{diamag} \\ \vdots \\ L_{C1 \to An}^{diamag} \end{pmatrix}, \quad L_{C2 \to A}^{diamag} = \begin{pmatrix} L_{C2 \to A1}^{diamag} \\ \vdots \\ L_{C2 \to An}^{diamag} \end{pmatrix}$$

$L_{C \to Ai}^{diamag}$ , $L_{C1 \to Ai}^{diamag}$ , $L_{C2 \to Ai}^{diamag}$ : inductive couplings of the further coil system (C, C', C", C''') or of the first or second partial coil system (C1, C2, C1' C2', C1", C2", C1''', C2''') with the i-th magnet partial coil system (Ai) in case of complete diamagnetic expulsion of field changes from the superconducting material volume in the magnet arrangement (M, M', M", M"),

$g_M$, $g_{M1}$, $g_{M2}$: field in the working volume (V) which is caused by the magnetization of the superconductor material in the magnet arrangement (M, M', M", M''') with a current change of one ampere in the further coil system (C, C', C", C''') or in the first or second partial coil system (C1, C2, C1' C2', C1", C2", C1''', C2''') in case of complete diamagnetic expulsion of field changes from the superconducting material volume in the magnet arrangement (M, M', M", M''') and taking into consideration the induced currents in the magnet partial coil systems (A1, A1', A1", A1''', A2''', ..., An'''),

n: number of magnet partial coil systems (A1, A1', A1", A1''', A2''', ..., An''') of the magnet coil system (A, A', A", A''').

2.

Magnet arrangement (M, M''') according to claim 1, **characterized in that** $g_{C1}^{eff,diamag}$ and $g_{C2}^{eff,diamag}$ are constructively superposed in the working volume (V) and $\dfrac{g_{C1}^{eff,class}}{g_{C1}^{eff,diamag}} > 1.05$ and $\dfrac{g_{C2}^{eff,class}}{g_{C2}^{eff,diamag}} < 0.95$ .

3.

Magnet arrangement (M', M", M''') according to claim 1, **characterized in that** $g_{C1}^{eff,diamag}$ and $g_{C2}^{eff,diamag}$ are

destructively superposed in the working volume (V) and

$$\frac{g_{C2}^{eff,class}}{g_{C2}^{eff,diamag}} \geq \frac{g_{C1}^{eff,class}}{g_{C1}^{eff,diamag}} > 1.05$$

or

$$\frac{g_{C2}^{eff,class}}{g_{C2}^{eff,diamag}} \leq \frac{g_{C1}^{eff,class}}{g_{C1}^{eff,diamag}} < 0.95 .$$

4.  Magnet arrangement (M, M''') according to any one of the preceding claims, **characterized in that** for at least one $i \in \{1,...,n\}$ the following applies:

$$\left| L_{C \rightarrow Ai}^{class} \right| < 0.01 \sqrt{L_{A.ii}^{class} \cdot L_C^{class}}$$

with:

$L_{A.ii}^{class}$ : matrix element in the i-th line and i-th column of the matrix $L_A^{class}$ ,

$L_C^{class}$ : overall inductance of the further coil system (C, C''') thereby neglecting any diamagnetic expulsion of fields from the superconductor material in the magnet arrangement (M, M''').

5.  Magnet arrangement (M', M'', M''') according to any one of the preceding claims, **characterized in that** at least one coil of the first partial coil system (C1', C1'', C1''') and one coil of the second partial coil system (C2', C2'', C2''') are wound on two different radii.

6.  Magnet arrangement (M, M'', M''') according to any one of the preceding claims, **characterized in that** at least one coil of the first partial coil system (C1, C1'', C1''') and one coil of the second partial coil system (C2, C2'', C2''') have different polarities.

7.  Magnet arrangement (M', M'', M''') according to any one of the preceding claims, **characterized in that** the magnet coil system (A', A'', A''') comprises active shielding.

8.  Magnet arrangement (M'', M''') according to any one of the preceding claims, **characterized in that** the further coil system (C'', C''') is designed to generate a field in the working volume (V) which, when superposed with the field of the magnet coil system (A'', A''') increases its inhomogeneity by a factor of maximally 2.

9.  Magnet arrangement (M, M', M'', M''') according to any one of the preceding claims, **characterized in that** the first partial coil system (C1, C1', C1'', C1''') or the second partial coil system (C2, C2', C2'', C2''') comprises at least one coil which is normally conducting.

10. Magnet arrangement (M, M', M'', M''') according to any one of the preceding claims, **characterized in that** the first partial coil system (C1, C1', C1'', C1''') or the second partial coil system (C2, C2', C2'', C2''') comprises at least one coil which is superconducting.

11. Magnet arrangement (M, M', M'', M''') according to claim 10, **characterized in that** the magnet coil system (A, A', A'', A''') and the further coil system (C, C', C'', C''') are disposed in a common container, wherein the container is designed to be filled with a cooling liquid and/or a device for active cooling of the container is provided.

12. Magnet arrangement (M, M', M'', M''') according to claim 10, **characterized in that** the magnet coil system (A, A', A", A"') and the further coil system (C, C', C", C"') are disposed in different containers, wherein the containers are designed to be filled with a cooling liquid and/or a device for active cooling of the containers is provided.

13. Magnet arrangement (M, M', M", M"') according to any one of the preceding claims, **characterized in that** the magnet arrangement is part of an apparatus for electron paramagnetic resonance (EPR) or for nuclear magnetic resonance (NMR).

14. Method for operating a magnet arrangement (M, M', M", M"') according to any one of the preceding claims, **characterized in that** at least one of the magnet partial coil systems (A1, A1', A1", A1"', A2"', ..., An"') generates a magnetic field of at least 1 T in the working volume (V) and wherein the overall magnetic field in the working volume (V), which is generated by the magnet partial coil systems (A1, A1', A1", A1"', A2"', ..., An"') and the further coil system (C, C', C", C"'), is varied by changing the current which flows in the further coil system (C, C', C", C"').

**Revendications**

1. Agencement magnétique (M, M', M", M"') destiné à générer un champ magnétique dans la direction d'un axe z dans un volume de travail (V) disposé sur l'axe z autour de z = 0 avec un système de bobines magnétiques (A, A', A", A"') qui comprend un ou plusieurs sous-systèmes de bobines magnétiques supraconductrices (A1, A1', A1", A1"', A2"', ..., An"') qui, dans l'état de fonctionnement, forment chacun un chemin de courant supraconducteur en court-circuit, le système de bobines magnétiques (A, A', A", A"') comprenant un matériau supraconducteur de type 2 qui, dans l'état de fonctionnement, se trouve dans un champ magnétique au-dessus de sa densité de flux magnétique critique inférieure, et avec un autre système de bobines (C, C', C", C"') pour générer une variation de champ magnétique, lequel peut être chargé ou déchargé indépendamment du système de bobines magnétiques (A, A', A", A"') et lequel comprend un premier et un deuxième sous-système de bobines (C1, C2, C1' C2', C1", C2", C1"', C2"'), le premier sous-système de bobines (C1, C1', C1", C1"') et le deuxième sous-système de bobines (C2, C2', C2", C2"') comprenant chacun au moins une bobine, toutes les bobines de l'autre système de bobines (C, C', C", C"') étant couplées en série, avec $\left| g_C^{eff.diamag} \right| > 0.1 mT/A$,

**caractérisé en ce**
**que** le système de bobines magnétiques (A, A', A", A"') et le premier et le deuxième sous-système de bobines (C1, C2, C1' C2', C1", C2", C1"', C2"') sont conçus de façon que

$$\left| g_{C1}^{eff.diamag} \right| > 0.1 mT/A , \quad \left| g_{C2}^{eff.diamag} \right| > 0.1 mT/A ,$$

$$\frac{g_{C1}^{eff.class}}{g_{C1}^{eff.diamag}} \notin [0.95, 1.05], \quad \frac{g_{C2}^{eff.class}}{g_{C2}^{eff.diamag}} \notin [0.95, 1.05]$$

et

$$\frac{g_C^{eff.class}}{g_C^{eff.diamag}} \in [0.95, 1.05],$$

avec

$$g_C^{eff.class} = g_C - g_A^T \cdot \left( L_A^{class} \right)^{-1} \cdot L_{C \to A}^{class},$$

$$g_{C1}^{eff.class} = g_{C1} - g_A^{\ T} \cdot \left(L_A^{class}\right)^{-1} \cdot L_{C1 \to A}^{class},$$

$$g_{C2}^{eff.class} = g_{C2} - g_A^{\ T} \cdot \left(L_A^{class}\right)^{-1} \cdot L_{C2 \to A}^{class},$$

$$g_C^{eff.diamag} = g_C - g_A^{\ T} \cdot \left(L_A^{diamag}\right)^{-1} \cdot L_{C \to A}^{diamag} + g_M,$$

$$g_{C1}^{eff.diamag} = g_{C1} - g_A^{\ T} \cdot \left(L_A^{diamag}\right)^{-1} \cdot L_{C1 \to A}^{diamag} + g_{M1},$$

$$g_{C2}^{eff.diamag} = g_{C2} - g_A^{\ T} \cdot \left(L_A^{diamag}\right)^{-1} \cdot L_{C2 \to A}^{diamag} + g_{M2}$$

avec :

$g_C$, $g_{C1}$, $g_{C2}$ : champ par ampère de courant de l'autre système de bobines (C, C', C", C'''), respectivement du premier ou deuxième sous-système de bobines (C1, C2, C1' C2', C1", C2", C1''', C2''') dans le volume de travail (V) sans les contributions au champ des sous-systèmes de bobines magnétiques (A1, A1', A1", A1''', A2''', ..., An''') et sans la contribution au champ de la magnétisation du matériau supraconducteur dans l'agencement magnétique (M, M', M", M'''), $g_A^T = (g_{A1}, ..., g_{Aj,} ... g_{An})$,

$g_{Aj}$ : champ par ampère de courant du $j^{ème}$ sous-système de bobines magnétiques (Aj) dans le volume de travail (V) sans les contributions au champ des $i^{ème}$ sous-systèmes de bobines magnétiques (Ai) pour $i \neq j$ et sans les contributions au champ de l'autre système de bobines (C, C', C", C''') et la magnétisation du matériau supraconducteur dans l'agencement magnétique (M, M', M", M'''),

$L_A^{class}$ : matrice n × n des inductances propres et des couplages inductifs entre les sous-systèmes de bobines magnétiques (A1, A1', A1", A1''', A2''', ..., An''') en négligeant tout refoulement diamagnétique de champs provenant du matériau supraconducteur dans l'agencement magnétique (M, M', M", M'''),

$$L_{C \to A}^{class} = \begin{pmatrix} L_{C \to A1}^{class} \\ \vdots \\ L_{C \to An}^{class} \end{pmatrix}, L_{C1 \to A}^{class} = \begin{pmatrix} L_{C1 \to A1}^{class} \\ \vdots \\ L_{C1 \to An}^{class} \end{pmatrix}, L_{C2 \to A}^{class} = \begin{pmatrix} L_{C2 \to A1}^{class} \\ \vdots \\ L_{C2 \to An}^{class} \end{pmatrix}$$

$L_{C \to Ai}^{class}$, $L_{C1 \to Ai}^{class}$, $L_{C2 \to Ai}^{class}$ : couplages inductifs de l'autre système de bobines (C, C', C", C'''), respectivement du premier ou deuxième sous-système de bobines (C1, C2, C1' C2', C1", C2", C1''', C2''') avec le $i^{ème}$ sous-système de bobines magnétiques (Ai) en négligeant tout refoulement diamagnétique de champs provenant du matériau supraconducteur dans l'agencement magnétique (M, M', M", M'''),

$L_A^{diamag}$ : matrice n × n des inductances propres et couplages inductifs entre les sous-systèmes de bobines magnétiques (A1, A1', A1", A1''', A2''', ..., An''') en cas de refoulement diamagnétique complet de variations de champ provenant de la part de matériau supraconducteur dans l'agencement magnétique (M, M', M", M'''),

$$L_{C\to A}^{diamag} = \begin{pmatrix} L_{C\to A1}^{diamag} \\ \vdots \\ L_{C\to An}^{diamag} \end{pmatrix}, \quad L_{C1\to A}^{diamag} = \begin{pmatrix} L_{C1\to A1}^{diamag} \\ \vdots \\ L_{C1\to An}^{diamag} \end{pmatrix}, \quad L_{C2\to A}^{diamag} = \begin{pmatrix} L_{C2\to A1}^{diamag} \\ \vdots \\ L_{C2\to An}^{diamag} \end{pmatrix}$$

$L_{C\to Ai}^{diamag}$, $L_{C1\to Ai}^{diamag}$, $L_{C2\to Ai}^{diamag}$ : couplages inductifs de l'autre système de bobines (C, C', C", C''') ou du premier ou deuxième sous-système de bobines (C1, C2, C1' C2', C1", C2", C1''', C2''') avec le i$^{\text{ème}}$ sous-système de bobines magnétiques (Ai) en cas de refoulement diamagnétique complet de variations de champ provenant de la part de matériau supraconducteur dans l'agencement magnétique (M, M', M", M'''),

$g_M$, $g_{M1}$, $g_{M2}$ : champ dans le volume de travail (V) qui provient de la magnétisation du matériau supraconducteur dans l'agencement magnétique (M, M', M", M''') lors d'une variation de courant d'un ampère dans l'autre système de bobines (C, C', C", C'''), respectivement dans le premier ou deuxième sous-système de bobines (C1, C2, C1' C2', C1", C2", C1''', C2'''), en cas de refoulement diamagnétique complet de variations de champ provenant de la part de matériau supraconducteur dans l'agencement magnétique (M, M', M", M''') et en tenant compte des courants induits dans les sous-systèmes de bobines magnétiques (A1, A1', A1", A1''', A2''', ..., An'''),

n : nombre de sous-systèmes de bobines magnétiques (A1, A1', A1", A1''', A2''', ..., An''') du système de bobines magnétiques (A, A', A", A''').

2.

Agencement magnétique (M, M''') selon la revendication 1, **caractérisé en ce que** $g_{C1}^{eff.diamag}$ et $g_{C2}^{eff.diamag}$ se superposent constructivement dans le volume de travail (V) et que $\dfrac{g_{C1}^{eff.class}}{g_{C1}^{eff.diamag}} > 1.05$ et $\dfrac{g_{C2}^{eff.class}}{g_{C2}^{eff.diamag}} < 0.95.$

3.

Agencement magnétique (M', M", M''') selon la revendication 1, **caractérisé en ce que** $g_{C1}^{eff.diamag}$ et $g_{C2}^{eff.diamag}$ se superposent destructivement dans le volume de travail (V) et que

$$\frac{g_{C2}^{eff.class}}{g_{C2}^{eff.diamag}} \ge \frac{g_{C1}^{eff.class}}{g_{C1}^{eff.diamag}} > 1.05$$

ou

$$\frac{g_{C2}^{eff.class}}{g_{C2}^{eff.diamag}} \le \frac{g_{C1}^{eff.class}}{g_{C1}^{eff.diamag}} < 0.95.$$

4. Agencement magnétique (M, M''') selon une des revendications précédentes, **caractérisé en ce que** pour au moins un $i \in \{1, ..., n\}$

$$\left| L_{C\to Ai}^{class} \right| < 0.01 \sqrt{L_{A.ii}^{class} \cdot L_C^{class}}$$

avec :

$\left| L_{A.ii}^{class} \right|$ : élément matriciel de la i$^{\text{ème}}$ ligne et de la i$^{\text{ème}}$ colonne de la matrice $L_A^{class}$,

$L_C^{class}$ : inductance totale de l'autre système de bobines (C, C''') en négligeant tout refoulement diamagnétique de champs provenant du matériau supraconducteur dans l'agencement magnétique (M, M''').

5. Agencement magnétique (M', M'', M''') selon une des revendications précédentes, **caractérisé en ce qu'**au moins une bobine du premier sous-système de bobines (C1', C1'', C1''') et une bobine du deuxième sous-système de bobines (C2', C2'', C2''') sont enroulées sur deux rayons différents.

6. Agencement magnétique (M, M'', M''') selon une des revendications précédentes, **caractérisé en ce qu'**au moins une bobine du premier sous-système de bobines (C1, C1'', C1''') et une bobine du deuxième sous-système de bobines (C2, C2'', C2''') présentent des polarités différentes.

7. Agencement magnétique (M', M'', M''') selon une des revendications précédentes, **caractérisé en ce que** le système de bobines magnétiques (A', A'', A''') comprend un blindage actif.

8. Agencement magnétique (M'', M''') selon une des revendications précédentes, **caractérisé en ce que** l'autre système de bobines (C'', C''') est conçu pour générer dans le volume de travail (V) un champ qui, superposé au champ du système de bobines magnétiques (A'', A'''), augmente son inhomogénéité au maximum d'un facteur 2.

9. Agencement magnétique (M, M', M'', M''') selon une des revendications précédentes, **caractérisé en ce que** le premier sous-système de bobines (C1, C1', C1'', C1''') ou le deuxième sous-système de bobines (C2, C2', C2'', C2''') comprend au moins une bobine qui est normalement conductrice.

10. Agencement magnétique (M, M', M'', M''') selon une des revendications précédentes, **caractérisé en ce que** le premier sous-système de bobines (C1, C1', C1'', C1''') ou le deuxième sous-système de bobines (C2, C2', C2'', C2''') comprend au moins une bobine qui est supraconductrice.

11. Agencement magnétique (M, M', M'', M''') selon la revendication 10, **caractérisé en ce que** le système de bobines magnétiques (A, A', A'', A''') et l'autre système de bobines (C, C', C'', C''') sont disposés dans un récipient commun, le récipient étant conçu pour être rempli d'un liquide de refroidissement et/ou un dispositif de refroidissement actif du récipient étant prévu.

12. Agencement magnétique (M, M', M'', M''') selon la revendication 10, **caractérisé en ce que** le système de bobines magnétiques (A, A', A'', A''') et l'autre système de bobines (C, C', C'', C''') sont disposés dans des récipients différents, les récipients étant conçus pour être remplis d'un liquide de refroidissement et/ou un dispositif de refroidissement actif des récipients étant prévu.

13. Agencement magnétique (M, M', M'', M''') selon une des revendications précédentes, **caractérisé en ce que** l'agencement magnétique fait partie d'un appareil pour la résonance paramagnétique électronique (= RPE) ou la résonance magnétique nucléaire (= RMN).

14. Procédé de fonctionnement d'un agencement magnétique (M, M', M'', M''') selon une des revendications précédentes, **caractérisé en ce qu'**un champ magnétique d'au moins 1 T est généré dans le volume de travail (V) avec au moins un des sous-systèmes de bobines magnétiques (A1, A1', A1'', A1''', A2''', ..., An''') et dans lequel, par variation du courant qui circule dans l'autre système de bobines (C, C', C'', C'''), on fait varier le champ magnétique total dans le volume de travail (V) qui est généré par les sous-systèmes de bobines magnétiques (A1, A1, A1'', A1''', A2''', ..., An''') et l'autre système de bobines (C, C', C'', C''').

**Fig. 1**

**Fig. 2**

**Fig. 3**

M'''

A1'''

A2'''

...

An'''

A'''

C'''

C1'''

C2'''

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10041672

**In der Beschreibung aufgeführte Nicht-Patentliteratur**

- **M.J. NILGES et al.** *Appl. Mag. Reson.,* 1999, vol. 16, 167-183
- **G.M. SMITH ; P.C. RIEDI.** Progress in high field EPR. Royal Society of Chemistry Specialist Periodical Reports, 2000, 17
- **M.N. WILSON.** Superconducting Magnets. Oxford University Press, 1983
- **D. SCHMALBEIN et al.** *Appl. Mag. Reson.,* 1999, vol. 16, 185-205
- **M.R. FUCHS.** *Diss. FU Berlin,* 2000
- **A.F. GULLÄ et al.** *Concepts in Magnetic Resonance,* 2002, vol. 15, 201-207